# EUROPEAN PATENT SPECIFICATION

(11) **EP 3 257 343 B1**
(45) Date of publication and mention of the grant of the patent: **18.11.2026**
(21) Application number: 15882234.6
(22) Date of filing: 13.02.2015
(51) Int. Cl.: H05K 7/20, H05K 7/18, H05K 7/14

(54) **COOLANT DISTRIBUTION UNIT**
KÜHLMITTELVERTEILUNGSEINHEIT
UNITÉ DE DISTRIBUTION DE RÉFRIGÉRANT

(43) Date of publication of application: 20.12.2017
(73) Proprietor: Hewlett Packard Enterprise Development LP, Spring, Texas 77389 (US)
(72) Inventor: CADER, Tahir, Houston, TX 77070 (US); FRANZ, John, Houston, TX 77070 (US)
(74) Representative: Marks & Clerk LLP
(86) International application number: PCT/US2015/015890
(87) International publication number: WO 2016/130152

(56) References cited:
- JP-A- 2005 228 216
- JP-A- 2012 118 781
- US-A1- 2005 133 214
- US-A1- 2005 133 214
- US-A1- 2008 018 212
- US-A1- 2009 260 384
- US-A1- 2010 236 772
- US-A1- 2011 075 373
- US-A1- 2011 315 353
- US-A1- 2011 315 353
- US-A1- 2013 333 865
- US-A1- 2014 124 189
- US-A1- 2014 133 096

## Description

### TECHNICAL FIELD

The present disclosure relates to a device comprising a coolant distribution unit and a method.

### BACKGROUND

Many current rack mounted computer systems utilize coolant distribution units (CDU) that are packaged into a large part of or all of a computer rack unit. This type of CDU is then used to facilitate cooling for a number of other computer rack units. However, having large CDUs as this tends to lower row level density, negatively impacting cluster availability, impacting customers' facility with a required secondary plumbing loop, and driving higher services costs. US 2013/333865 A1 describes field-replaceable, modular pumping units, configured to facilitate pumping coolant through a cooling apparatus assisting in removal of heat generated by one or more electronic systems. The cooling apparatus includes one or more heat exchange assemblies, and the modular pumping units are coupled in parallel fluid communication to the cooling apparatus. The modular pumping unit includes a housing, a coolant inlet to the housing, a coolant reservoir tank disposed within the housing, a coolant pump, and a coolant outlet of the housing. The coolant reservoir tank and coolant pump are disposed within the housing in fluid communication, and the coolant pump pumps coolant from the coolant reservoir tank to the coolant outlet of the housing. A modular pumping unit controller is associated with the modular pumping unit, and automatically adjusts operation of the coolant pump based upon one or more sensed parameters. The field-replaceable, modular pumping units may provide pumped coolant for circulation through various types of heat exchange assemblies, including a coolant-to-air heat exchanger, a liquid-to-liquid heat exchanger, a rack-mounted door heat exchanger, a coolant-to-refrigerant heat exchanger, etc. Further, the heat exchange assembly may comprise more than one heat exchanger, including more than one type of heat exchanger. The heat exchange assembly could be within the liquid-cooled electronics rack, or positioned remotely from the rack. Not disclosed is a liquid-to-liquid heat exchanger in the rear door. US 2010/236772 A1 describes an equipment cooling system and method employing modular scalable coolant distribution units that interface with each other to provide liquid cooling for computer data centers. The coolant distribution unit (CDU) permits the use of elevated water temperatures without increasing the load on the computer room air conditioning. A control unit processes environment data to control pump and valve components supporting redundancy and multiple primary and secondary coolant loops. US 2011/315353 A1 describes liquid-cooled electronics racks which include: immersion-cooled electronic subsystems; a vertically-oriented, vapor-condensing unit facilitating condensing dielectric fluid vapor egressing from the immersion-cooled subsystems, the vertically-oriented, vapor-condensing unit being sized and configured to reside adjacent to at least one side of the electronics rack; a reservoir for holding dielectric fluid, the reservoir receiving dielectric fluid condensate from the vertically-oriented, vapor-condensing unit; a dielectric fluid supply manifold coupling in fluid communication the reservoir and the dielectric fluid inlets of the immersion-cooled electronic subsystems; and a pump associated with a reservoir for pumping under pressure dielectric fluid from the reservoir to the dielectric fluid supply manifold for maintaining dielectric fluid in a liquid state within the immersion-cooled electronic subsystems. JP 2005 228216 describes a cooling structure in an electronic apparatus. It is described that incorporating a heat exchanger in a wide range into the door portion of the rack casing is effective in improving the liquid cooling performance. That is, the heat exchanger that cools the cooling liquid of the processor unit in the housing rack in a lump is cooled on the inner surface of the rear housing door. The fan unit which air-cools the heat exchanger is arranged and installed in the surface of the back side housing door. An intake header to be connected and a pump for circulating the liquid refrigerant are installed. US 2014/124189 describes a coolant-conditioning unit comprising a reservoir tank with liquid level sensors to monitor the level of the system coolant and a pressure relief valve. US2014133096A1 describes a cooling apparatus for an electronics rack which includes a door assembly coupled to the electronics rack at an inlet or air outlet side of the rack. The door assembly includes: an airflow opening configured to facilitate ingress or egress of airflow through the electronics rack with the door assembly mounted to the rack; an air-to-coolant heat exchanger disposed so that airflow through the airflow opening passes across the air-to-coolant heat exchanger, the air-to-coolant heat exchanger being configured to extract heat from the airflow passing there across; and a vapor condenser configured to facilitate condensing of dielectric fluid vapor egressing from at least one immersion-cooled electronic component section of the electronics rack. The cooling apparatus, including the door assembly, facilitates air-cooling and immersion-cooling of different electronic components of the electronics rack.

### SUMMARY

According to a first aspect, there is provided a device as recited in claim 1. According to a second aspect, there is provided a method as recited in claim 6.

### BRIEF DESCRIPTION OF THE DRAWINGS

For a more complete understanding of various examples, reference is now made to the following description taken in connection with the accompanying drawings in which:
Figure 1 illustrates an example computer rack unit including a rear door heat exchanger and housing an example coolant distribution unit;
Figure 2 illustrates a perspective view of interior components of a coolant distribution unit housed in a computer rack unit;
Figure 3 illustrates an example block diagram of components of a coolant distribution unit; and
Figure 4 illustrates an example flow diagram for an example process for cooling liquid cooled computing units.

### DETAILED DESCRIPTION

Example systems and methods described herein combine a small (e.g., about 3U rack units where one U occupies about 1.75 inches vertical rack space) CDU combined with a rear door heat exchanger of a computer rack unit. Such a configuration takes advantage of unused rear door space to mount a liquid-to-liquid heat exchanger.

Various example CDUs described herein are rack-based units that distribute coolant (water, refrigerant, etc.) to liquid-cooled rack mounted information technology (IT) equipment such as servers, networking equipment, storage equipment, referred to herein as liquid-cooled computing units. The CDU typically consists of a pump, a variable frequency drive (VFD) providing variable speeds to the pump, a liquid-to-liquid (or liquid-to-air) heat exchanger (HX), a controller, a reservoir, and piping.

Typically, the pump(s) and VFD, HX, and reservoir are the largest components and take up the most room. The larger the cooling capacity of the CDU, the larger the HX needs to be. CDUs are usually mounted in a dedicated rack that takes up a single rack footprint. In addition, increasing the number of computer racks does not tend to improve the row density. In contrast, models for the CDUs described herein are more attractive than the current deployment model. For example, a rack-based CDU in combination with a rear door heat exchanger, as described herein, may take up 3U of a 42U rack in contrast to a dedicated whole rack CDU occupying the entire 42U space of one rack.

If a small rack-based CDU fails, only one rack is affected. In addition, by putting multiple pumps in a CDU of a rack, a great deal of redundancy is obtained since the pumps tend to be the most failure prone component of a CDU.

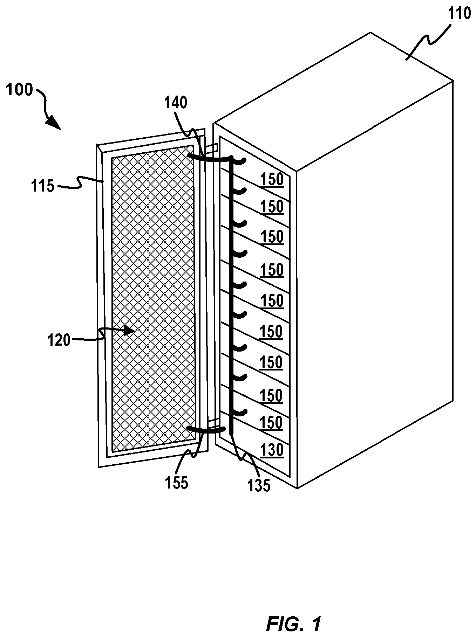

Referring now to the figures, Figure 1 illustrates an example computer rack unit 100 including a rear door heat exchanger 120 and housing an example coolant distribution unit (CDU) 130. The computer rack unit 100 includes a housing 110 configured to house a plurality of liquid cooled computing units 150. The rear door heat exchanger 120 is coupled to a rear door 115 which is coupled to the housing 110. The rear door heat exchanger 120 is a liquid-to-liquid heat exchanger which circulates a first coolant (which may include water or other refrigerant) to cool a second coolant (which may include water or other refrigerant) of the CDU 130, where the second coolant cools the computing units 150. The first and second coolants are each in separate coolant loops. The first coolant may be water from a facility such as a building housing the computer rack unit 100. In examples where some of the computing units 150 housed in the computer rack unit 100 are not liquid cooled, a liquid-to-air heat exchanger could be embedded in the rack unit 100 or, alternatively, the rear door 115 may include a liquid-to-air heat exchanger in addition to the liquid-to-liquid heat exchanger 120 to allow air flow into the interior of the housing 110 to cool the non-liquid cooled computing units within the housing 110.

The rear door heat exchanger 115 comprises a fluid flow path, not shown, to receive heated coolant from the liquid cooled computing units 150 via a heat exchanger intake line 155 in order to cool the heated coolant. The example coolant distribution unit 130 is fully contained within the housing 110. A first fluid line, e.g., a fluid supply line 135, is coupled to the coolant distribution unit 130 and supplies coolant to the liquid cooled computing units 150. A second fluid line, e.g., a fluid return line 140, returns the cooled fluid from the rear door heat exchanger 120 to the coolant distribution unit 130. In the example computer rack 100, the coolant distribution unit 130 is located at the bottom of the housing 110. This may be advantageous if a leak develops in the coolant distribution unit 130. Other various example computer rack units may position a coolant distribution unit at the top of the housing 110 or under a floor that the computer rack unit is positioned on.

In various examples, a rear door liquid-to-liquid heat exchanger 120 is mounted on the rear door 115 of the computer rack unit 100. The use of a liquid-to-liquid heat exchanger 120 on the rear door 115 may give a much greater performance than comparably sized liquid-to-air heat exchangers. For example, an 80 kW liquid-to-liquid heat exchanger may require about 25 gallons/minute (gpm) of 30C water, and would be smaller than a comparable 50 kW liquid-to-air heat exchanger.

In various examples, the coolant used in the coolant distribution unit 130 may be water which would allow the coolant distribution unit 130 to be connected directly into facility plumbing, and may not need dedicated secondary plumbing. This may have a significant effect in reducing deployment and services costs, and improving rack-level serviceability.

In various examples, use of the rack-based coolant distribution unit 130 may result in smaller catastrophic leaks. For example, a catastrophic leak in a rack will take the single rack down. For designs utilizing a full rack coolant distribution unit for multiple computer rack units, a catastrophic leak may take down the entire cluster.

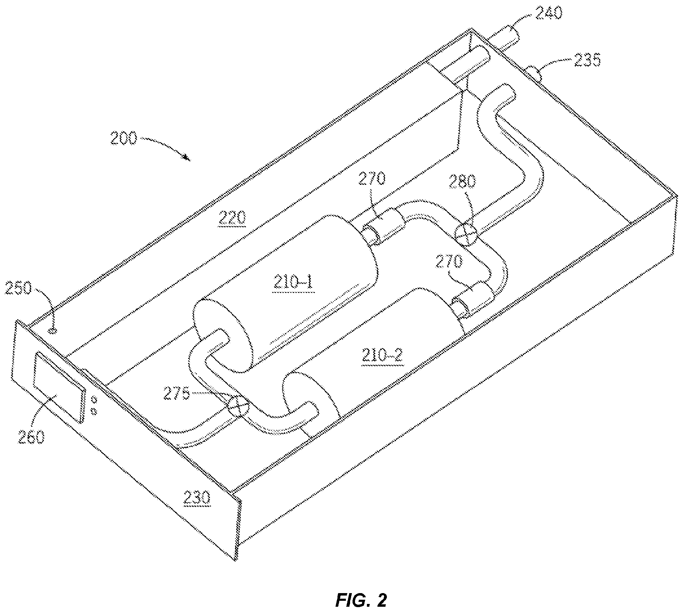

Figure 2 illustrates an elevational view of components of a coolant distribution unit 200 that may be housed in a computer rack unit, such as the computer rack unit 100 of Figure 1 and paired with the rear door liquid-to-liquid heat exchanger 120. In this example, the coolant distribution unit 200 may be housed in a coolant distribution unit chassis 230 which may be about 17 ½ inches wide and 3U high, where 3U corresponds to about 5.25 inches. The coolant distribution unit 200 includes a first pump 210-1 and a second pump 210-2 arranged in parallel. Outputs of the pumps 210 are coupled to a coolant supply line 235 that may supply pumped coolant to the liquid cooling units 150 as illustrated in Figure 1.

The coolant distribution unit 200 also includes a reservoir 220 that is coupled to a coolant return line 240 that may receive coolant from the heat exchanger 120. The reservoir 220 may provide a capacity great enough to be used to contain coolant that is received from the heat exchanger 120, where the coolant may vary in volume due to temperature variations of the coolant. The reservoir is equipped with a pressure release valve that may be used to release excess coolant and/or gas. The reservoir may also be equipped with a drain port 250 that may be used to release excess coolant and/or gas.

The coolant distribution unit 200 may also include a pair of backflow prevention or check valves 270.

The coolant distribution unit 200 may also include a status display 260 to display the status of the cooling system. The status may be in the form of a maximum temperature of the coolant and/or the computing units 150, for example.

The parallel first and second pumps 210-1 and 210-2 may be equipped with a pair of isolation valves including a first isolation valve 275 and a second isolation valve 280. The isolation valves 275 and 280 may be used to restrict flow to one of the parallel pumps 210 allowing this pump to remain in operation while the other pump 210 is hot swapped out when in need of repair. Such redundancy provides added security to the overall cooling system for each rack containing one of the coolant distribution units 200.

In various examples, at the an assumed maximum power density of about 80 kW per rack, approximately 25 gpm of 30C water may be required by the computing units 150 of one computer rack unit 100. If the water temperature is lowered below 30C, the pumping power and pump size may decrease, and/or the size of the heat exchanger 120 may decrease. In various examples, if liquid-cooled cold plates are used on the computing units 150, a lower thermal resistance of this technology may enable much lower flow rate and pumping power demands. For example, at an assumed maximum power density of about 40 kW for a rack including computing units 150 with liquid-cooled cold plates (this is an example configuration), analysis suggests that as little as 10 gpm of water at 33C may be sufficient.

In various examples, the first and second pumps 210-1 and 210-2 may comprise any type of pumps known to those skilled in the art. Each computer rack unit 100 may be equipped with a leak containment/prevention/detection system.

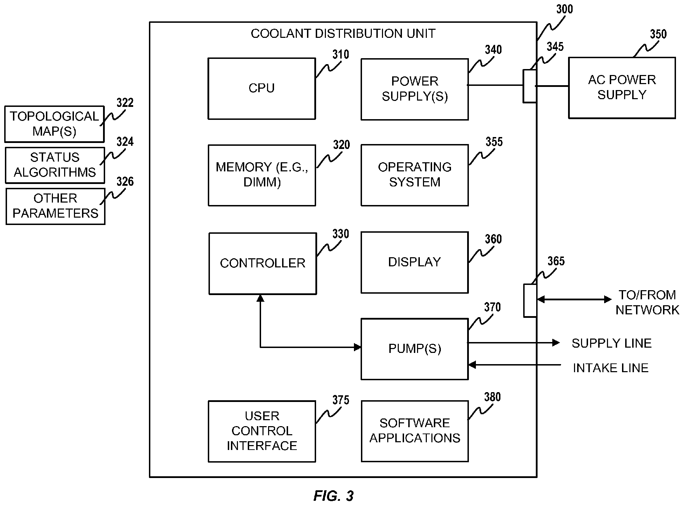

Referring now to Figure 3, an example block diagram of components of a coolant distribution unit 300 is illustrated. The coolant distribution unit 300 may be used, for example, as the coolant distribution unit 130 of Figure 1, or the coolant distribution unit 200 of Figure 2. The example coolant distribution unit 300 may utilize an example controller 330 for controlling the coolant flow through the plurality of computing units 150 housed in the computer rack unit 100 of Figure 1. The example coolant distribution unit 300 may include embedded firmware and hardware components in order to continually collect data associated with temperature of the coolant and/or temperatures of the computing units 150 illustrated in Figure 1.

The example coolant distribution unit 300 may include a server CPU (central processing unit) 310, at least one memory device 320, and a power supply 340. The power supply 340 is coupled to an electrical interface 345 that is coupled to an external power supply such as an AC power supply 350. The coolant distribution unit 300 may also include an operating system component 355 including, for example, an operating system driver component and a pre-boot BIOS (Basic Input/Output System) component stored in ROM (read only memory), and coupled to the CPU 310. In various examples, the CPU 310 may have a non-transitory memory device 320. In various examples, the memory device 320 may be integrally formed with the CPU 310 or may be an external memory device. The memory device 320 may include program code that may be executed by the CPU 320. For example, one or more processes may be performed to execute a user control interface 375 and/or software applications 380.

The example coolant distribution unit 300 may incorporate a standalone server such as a blade server housed within one of the rack based coolant distribution units 130 or 200 of Figures 1 and 2. Alternatively, portions of the coolant distribution unit 300 such as, for example, the CPU 310, the memory device 320, the operating system 355, the user control interface 375 and/or the software applications 380 may be part of one of the other computing units 150 housed in the computer rack unit 100.

The controller 330 may be implemented in software, firmware and/or hardware. The controller 330 may receive signals representative of a coolant temperature, temperatures of the liquid cooled computing units 150, coolant flow rate, power consumption, pump speed, etc. The signals representative of the coolant temperatures may be reported to the controller by temperatures sensors. The pumps 210 illustrated in the coolant distribution unit 200 of Figure 2 may report signals representative of power consumption, speed, cumulative number of revolutions to the controller 330. The controller 330 may receive the signals representative of the temperatures of the computing units 150 via a network interface 365 which may be communicatively coupled to the computing units 150. The controller 330 may use the coolant temperature and/or the temperatures of the liquid cooled computing units 150 to control speeds of the pumps 370.

The network interface 365 may be coupled to a network such as an intranet, a local area network (LAN), a wireless local area network (WLAN), the Internet, etc., where the other liquid cooled computing units 150 may be a part of the network or at least coupled to the network. The coolant distribution unit 300 may also include a display 360 which may be an example of the display 260 illustrated in Figure 2.

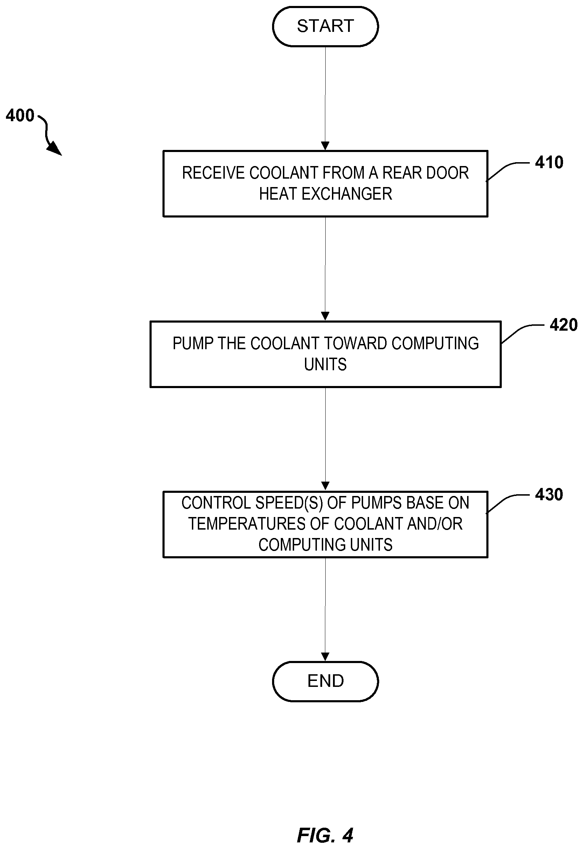

Figure 4 illustrates an example flow diagram for an example process 400 for cooling liquid cooled computing units. The process 400 is exemplary only and may be modified. The example process 400 of Figure 4 will now be described with further references to Figures 1, 2 and 3.

Referring now to Figure 4, the coolant distribution unit 200 or 300 receives coolant from the rear door heat exchanger 120 via a coolant fluid return line 240. At block 420, the coolant distribution unit 200 or 300 pumps the coolant toward the liquid cooled computing units 150 using at least one of the two parallel pumps 210 that are both coupled to the coolant fluid return line 240 so as to supply the coolant to the liquid cooled computing units 150 via the coolant fluid supply line 235 coupled to the plurality of liquid cooled computing units 150.

At block 430, the controller 330 may control speeds of one or both of the parallel pumps 210 based on temperature of the coolant and/or temperatures of the liquid cooled computing units. In various examples, the controller 330 may receive signals representative of a coolant temperature and/or signals representative of temperatures of the liquid cooled computing units 150. The signals representative of the coolant temperatures may be received from one or both of the parallel pumps 210. The controller 330 may receive the signals representative of the temperatures of the computing units 150 via the network interface 365 which may be communicatively coupled to the computing units 150.

Various examples described herein are described in the general context of method steps or processes, which may be implemented in one example by a software program product or component, embodied in a machine-readable medium, including executable instructions, such as program code, executed by entities in networked environments. Generally, program modules may include routines, programs, objects, components, data structures, etc. which may be designed to perform particular tasks or implement particular abstract data types. Executable instructions, associated data structures, and program modules represent examples of program code for executing steps of the methods disclosed herein. The particular sequence of such executable instructions or associated data structures represents examples of corresponding acts for implementing the functions described in such steps or processes.

Software implementations of various examples can be accomplished with standard programming techniques with rule-based logic and other logic to accomplish various database searching steps or processes, correlation steps or processes, comparison steps or processes and decision steps or processes.

The foregoing description of various examples has been presented for purposes of illustration and description. The foregoing description is not intended to be exhaustive or limiting to the examples disclosed, and modifications and variations are possible in light of the above teachings or may be acquired from practice of various examples. The examples discussed herein were chosen and described in order to explain the principles and the nature of various examples of the present disclosure and its practical application to enable one skilled in the art to utilize the present disclosure in various examples and with various modifications as are suited to the particular use contemplated. The features of the examples described herein may be combined in all possible combinations of methods, apparatus, modules, systems, and computer program products.

It is also noted herein that while the above describes examples, these descriptions should not be viewed in a limiting sense. Rather, there are several variations and modifications which may be made without departing from the scope as defined in the appended claims.

## Claims

1. A device, comprising:
a housing (110) configured to house a plurality of liquid cooled computing units (150);
a rear door (115) coupled to the housing (110), the rear door (115) comprising a liquid to liquid heat exchanger (120), the liquid to liquid heat exchanger (120) comprising a fluid flow path configured to receive heated coolant from the liquid cooled computing units (150) and cool the heated coolant, wherein the liquid to liquid heat exchanger (120) is configured to circulate a second coolant to cool the heated coolant; and
a coolant distribution unit (130) contained within the housing (110), the coolant distribution unit (130) comprising:
a first fluid line (240), coupled to the fluid flow path of the liquid to liquid heat exchanger (120), configured to receive the coolant;
at least one pump (210-1, 210-2) coupled to the first fluid line (240) via a reservoir (220), configured to pump the coolant toward the liquid cooled computing units (150); and
a second fluid line (235), configured to couple to the plurality of liquid cooled computing units (150) and the at least one pump, configured to supply the coolant to the liquid cooled computing units (150);
wherein the reservoir (220) is configured to contain the coolant and is coupled to the first fluid line (240), wherein the reservoir (220) comprises a pressure relief valve configured to release pressure from the reservoir (220).

2. The device of claim 1, further comprising a controller (330), executed on a processor, configured to control a speed of the at least one pump (210-1, 210-2) based on temperature of the coolant and/or temperatures of the liquid cooled computing units (150).

3. The device of claim 1, wherein the housing (10) comprises one or more non-liquid cooled computing units.

4. The device of claim 1, wherein the coolant distribution unit (130) is located at a bottom of the housing (110).

5. The device of claim 1, wherein the at least one pump comprises at least two pumps and the at least two pumps (210-1, 210-2) are configured to be isolated from each other to enable hot swapping of a first pump (210-1) of the at least two pumps while a second pump (210-2) of the at least two pumps is in operation.

6. A method (400), comprising:
receiving (410), at a first fluid line (240) of a coolant distribution unit (130) contained within a housing, coolant from a rear door liquid to liquid heat exchanger of the housing, wherein the liquid to liquid heat exchanger (120) is configured to circulate a second coolant to cool the heated coolant, wherein the coolant distribution unit (130) comprises a reservoir (220) to contain the coolant, wherein the reservoir (220) comprises a pressure relief valve to release pressure from the reservoir (220);
pumping (420) the coolant toward liquid cooled computing units contained within the housing using at least one variable speed pump (210-1, 210-2) coupled to the first fluid line (240) via the reservoir (220) to supply the coolant to the liquid cooled computing units (150) via a second fluid line (235) coupled to the plurality of liquid cooled computing units (150).

7. The method of claim 6, further comprising controlling (430) a speed of the at least one variable speed pump (210-1, 210-2) based on temperature of the coolant and/or temperatures of the liquid cooled computing units (150).

8. The method of claim 6, further comprising pumping the coolant toward the liquid cooled computing units (150) contained within the housing (110) using at least two variable speed pumps (210-1, 210-2).

9. The method of claim 8, wherein the at least two pumps (210-1, 210-2) are configured to be isolated from each other, the method further comprising hot swapping a first pump (210-1) of the at least two pumps while a second pump (210-2) of the at least two pumps is in operation.

## Patentansprüche

1. Vorrichtung, umfassend:
ein Gehäuse (110), das konfiguriert ist, um eine Vielzahl von flüssigkeitsgekühlten Recheneinheiten (150) aufzunehmen;
eine mit dem Gehäuse (110) gekoppelte rückwärtige Tür (115), wobei die rückwärtige Tür (115) einen Flüssig-Flüssig-Wärmetauscher (120) umfasst, wobei der Flüssig-Flüssig-Wärmetauscher (120) einen Fluidströmungsweg umfasst, der konfiguriert ist, um erwärmtes Kühlmittel aus den flüssigkeitsgekühlten Recheneinheiten (150) in Empfang zu nehmen und das erwärmte Kühlmittel zu kühlen, wobei der Flüssig-Flüssig-Wärmetauscher (120) konfiguriert ist, um ein zweites Kühlmittel zur Kühlung des erwärmten Kühlmittels zirkulieren zu lassen; und
eine Kühlmittelverteilungseinheit (130), die in dem Gehäuse (110) untergebracht ist, wobei Kühlmittelverteilungseinheit (130) Folgendes umfasst:
eine erste Fluidleitung (240), die mit dem Fluidströmungsweg des Flüssig-Flüssig-Wärmetauschers (120) gekoppelt ist und konfiguriert ist, um das Kühlmittel in Empfang zu nehmen;
mindestens eine Pumpe (210-1, 210-2), die über einen Vorratsbehälter (220) mit der ersten Fluidleitung (240) gekoppelt ist und konfiguriert ist, um das Kühlmittel zu den flüssigkeitsgekühlten Recheneinheiten (150) zu pumpen; und
eine zweite Fluidleitung (235), die konfiguriert ist, um mit der Vielzahl von flüssigkeitsgekühlten Recheneinheiten (150) und der mindestens einen Pumpe gekoppelt zu werden, und konfiguriert ist, um das Kühlmittel den flüssigkeitsgekühlten Recheneinheiten (150) zuzuführen;
wobei der Vorratsbehälter (220) konfiguriert ist, um das Kühlmittel zu enthalten, und mit der ersten Fluidleitung (240) gekoppelt ist, wobei der Vorratsbehälter (220) ein Überdruckventil umfasst, das konfiguriert ist, um Druck aus dem Vorratsbehälter (220) abzulassen.

2. Vorrichtung nach Anspruch 1, weiter umfassend einen auf einer Prozessor ausgeführte Steuereinheit (330), der konfiguriert ist, um eine Drehzahl der mindestens einen Pumpe (210-1, 210-2) in Abhängigkeit von der Kühlmitteltemperatur und/oder den Temperaturen der flüssigkeitsgekühlten Recheneinheiten (150) zu regeln.

3. Vorrichtung nach Anspruch 1, wobei das Gehäuse (10) eine oder mehrere nicht flüssigkeitsgekühlte Recheneinheiten umfasst.

4. Vorrichtung nach Anspruch 1, wobei sich die Kühlmittelverteilungseinheit (130) am Boden des Gehäuses (110) befindet.

5. Vorrichtung nach Anspruch 1, wobei die mindestens eine Pumpe mindestens zwei Pumpen umfasst und die mindestens zwei Pumpen (210-1, 210-2) so konfiguriert sind, dass sie voneinander isoliert sind, um einen Austausch einer ersten Pumpe (210-1) der mindestens zwei Pumpen während des laufenden Betriebs zu ermöglichen, während eine zweite Pumpe (210-2) der mindestens zwei Pumpen in Betrieb ist.

6. Verfahren (400), umfassend:
Empfangen (410), an einer ersten Fluidleitung (240) einer in einem Gehäuse untergebrachten Kühlmittelverteilungseinheit (130), von Kühlmittel von einem Flüssig-Flüssig-Wärmetauscher an der rückseitigen Tür des Gehäuses, wobei der Flüssig-Flüssig-Wärmetauscher (120) konfiguriert ist, um ein zweites Kühlmittel zur Kühlung des erwärmten Kühlmittels zirkulieren zu lassen, wobei die Kühlmittelverteilungseinheit (130) einen Vorratsbehälter (220) zur Aufnahme des Kühlmittels umfasst, wobei der Vorratsbehälter (220) ein Überdruckventil zum Ablassen von Druck aus dem Vorratsbehälter (220) umfasst;
Pumpen (420) des Kühlmittels zu den in dem Gehäuse untergebrachten flüssigkeitsgekühlten Recheneinheiten unter Verwendung mindestens einer drehzahlvariablen Pumpe (210-1, 210-2), die über den Vorratsbehälter (220) mit der ersten Fluidleitung (240) gekoppelt ist, um das Kühlmittel über eine zweite Fluidleitung (235), die mit der Vielzahl von flüssigkeitsgekühlten Recheneinheiten (150) gekoppelt ist, der Vielzahl von flüssigkeitsgekühlten Recheneinheiten (150) zuzuführen.

7. Verfahren nach Anspruch 6, weiter umfassend das Regeln (430) einer Drehzahl der mindestens einen drehzahlvariablen Pumpe (210-1, 210-2) in Abhängigkeit von der Kühlmitteltemperatur und/oder den Temperaturen der flüssigkeitsgekühlten Recheneinheiten (150).

8. Verfahren nach Anspruch 6, weiter umfassend das Pumpen des Kühlmittels zu den in dem Gehäuse (110) enthaltenen flüssigkeitsgekühlten Recheneinheiten (150) unter Verwendung von mindestens zwei drehzahlvariablen Pumpen (210-1, 210-2).

9. Verfahren nach Anspruch 8, wobei die mindestens zwei Pumpen (210-1, 210-2) voneinander isoliert sind, wobei das Verfahren ferner das Austauschen einer ersten Pumpe (210-1) der mindestens zwei Pumpen im laufenden Betrieb umfasst, während eine zweite Pumpe (210-2) der mindestens zwei Pumpen in Betrieb ist.

## Revendications

1. Dispositif, comprenant :
un boîtier (110) configuré pour loger une pluralité d'unités de calcul refroidies par un liquide (150) ;
une porte arrière (115) fixée au boîtier (110), la porte arrière (115) comprenant un échangeur de chaleur liquide-liquide (120), l'échangeur de chaleur liquide-liquide (120) comprenant un trajet d'écoulement de fluide configuré pour recevoir un fluide de refroidissement chauffé en provenance des unités de calcul refroidies par un liquide (150) et refroidir le fluide de refroidissement chauffé, dans lequel l'échangeur de chaleur liquide-liquide (120) est configuré pour faire circuler un second fluide de refroidissement pour refroidir le fluide de refroidissement chauffé ; et
une unité de distribution de liquide de refroidissement (130) contenue dans le boîtier (110), l'unité de distribution de liquide de refroidissement (130) comprenant :
une première conduite de fluide (240), couplée au trajet d'écoulement du fluide de l'échangeur de chaleur liquide-liquide (120), configurée pour recevoir le fluide de refroidissement ;
au moins une pompe (210-1, 210-2) couplée à la première conduite de fluide (240) via un réservoir (220), configurée pour pomper le liquide de refroidissement vers les unités de calcul refroidies par un liquide (150) ; et
une seconde conduite de fluide (235), configurée pour être couplée à la pluralité d'unités de calcul refroidies par un liquide (150) et à la au moins une pompe, configurée pour fournir le liquide de refroidissement aux unités de calcul refroidies par un liquide (150) ;
dans lequel le réservoir (220) est configuré pour contenir le liquide de refroidissement et est couplé à la première conduite de fluide (240), dans lequel le réservoir (220) comprend une vanne de surpression configurée pour libérer la pression du réservoir (220).

2. Dispositif selon la revendication 1 comprend en outre un dispositif de commande (330), exécuté sur un processeur, configuré pour réguler la vitesse de l'au moins une pompe (210-1, 210-2) sur la base de la température du fluide de refroidissement et/ou des températures des unités de calcul refroidies par un liquide (150).

3. Dispositif selon la revendication 1, dans lequel le boîtier (10) comprend une ou plusieurs unités de calcul non refroidies par un liquide.

4. Dispositif selon la revendication 1, dans lequel l'unité de distribution de liquide de refroidissement (130) est située au fond du boîtier (110).

5. Dispositif selon la revendication 1, dans lequel la au moins une pompe comprend au moins deux pompes et les au moins deux pompes (210-1, 210-2) sont configurées pour être isolées l'une de l'autre afin de permettre le remplacement à chaud d'une première pompe (210-1) des au moins deux pompes pendant qu'une seconde pompe (210-2) des au moins deux pompes est en fonctionnement.

6. Procédé (400) comprenant :
la réception (410), au niveau d'une première conduite de fluide (240) d'une unité de distribution de liquide de refroidissement (130) contenue dans un boîtier, d'un liquide de refroidissement en provenance d'un échangeur de chaleur liquide-liquide de porte arrière du boîtier, dans lequel l'échangeur de chaleur liquide-liquide (120) est configuré pour faire circuler un second liquide de refroidissement afin de refroidir le liquide de refroidissement chauffé, dans lequel l'unité de distribution de liquide de refroidissement (130) comprend un réservoir (220) pour contenir le liquide de refroidissement, dans lequel le réservoir (220) comprend une vanne de surpression pour libérer la pression du réservoir (220) ;
le pompage (420) du liquide de refroidissement vers les unités de calcul refroidies par un liquide contenues dans le boîtier à l'aide d'au moins une pompe à vitesse variable (210-1, 210-2) couplée à la première conduite de fluide (240) via le réservoir (220) pour fournir le liquide de refroidissement aux unités de calcul refroidies par un liquide (150) via une seconde conduite de fluide (235) couplée à la pluralité d'unités de calcul refroidies par un liquide (150).

7. Procédé selon la revendication 6 comprend en outre la régulation (430) de la vitesse de l'au moins une pompe à vitesse variable (210-1, 210-2) sur la base de la température du fluide de refroidissement et/ou de températures des unités de calcul refroidies par un liquide (150).

8. Procédé selon la revendication 6, comprenant en outre le pompage du liquide de refroidissement vers les unités de calcul refroidies par un liquide (150) contenues dans le boîtier (110) à l'aide d'au moins deux pompes à vitesse variable (210-1, 210-2).

9. Procédé selon la revendication 8, dans lequel les au moins deux pompes (210-1, 210-2) sont configurées pour être isolées l'une de l'autre, le procédé comprenant en outre le remplacement à chaud d'une première pompe (210-1) des au moins deux pompes pendant qu'une seconde pompe (210-2) des au moins deux pompes est en fonctionnement.
